# EUROPEAN PATENT APPLICATION

(11) **EP 4 793 706 A1**
(43) Date of publication of application: **19.08.2026**
(21) Application number: 26159089.7
(22) Date of filing: 17.02.2026
(51) Int. Cl.: G03F 9/00

(54) **APPARATUS FOR ACCURATELY MOVING A STAMP TO A SUBSTRATE**

(30) Priority: 18.02.2025 NL 2039790
(71) Applicant: MI-Partners BV, 5507 TB Veldhoven (NL)
(72) Inventor: SCHNEIDER, Ronald Maarten, 5655 JX Eindhoven (NL)
(74) Representative: Verhees, Godefridus Josephus Maria

(57) **Abstract**

In an apparatus for accurately moving a stamp to a substrate, the stamp (3) is moved in the z-direction over a greater distance than in the x- and y-directions. The apparatus (1) comprises three plane mirrors (7), which are present perpendicular to the z-direction on the top side of the stamp (3), and three pairs (9) of further plane mirrors (11), with the two further plane mirrors (11) of each pair (9) at right angles to each other. The further plane mirrors (11) are elongated and extend in z-direction and are attached to the stamp (3) at three different locations. The apparatus (1) further comprises three interferometers (15) which are present at a distance above the stamp (3), and three further interferometers (19) which are present at a distance next to the stamp (3). Adjacent each further interferometer (19) a zero-shear mirror (23) is arranged.

## Description

### Technical field of the invention

For imprint or bonding applications, a stamp or die should be made in contact with a substrate or wafer or die with very good overlay accuracy. First to measure the alignment between stamp and substrate a camera will look up to markers on the stamp and down to markers on the substrate (well known technology). After that typically, the stamp or the substrate will move up or down (z-direction) and make contact. This down moving motion should be very accurate with respect to the camera position measurement. Typically this z-motion is between 20-100 mm.

This invention is about an apparatus for accurately moving a stamp to a substrate in such a way that the position in the x,y-plane and the orientation about the x-, y- and z-axies is maintained accurate, by measuring the displacement in the x-, y- and z-directions and the rotation about the x-, y- and z-axes of the stamp. Since the stamp should be aligned to the substrate, motions in plane (x,y-plane) are a few millimeters and rotations of a few degrees.

### Background of the invention

A known solution is to measure the position with interferometers to plane mirrors while moving in z-direction. The problem is then limited allowed rotation (Rz), since the interferometer beam will not be reflected back. A solution to overcome this problem is to use corner cubes prism or retroreflector (three mirror surfaces at 90 degrees). That allows rotations in tip/tilt (Rx/Ry) and Rz. This will allow larger rotations, but does not allow for the large z-stroke.

### Summary of the invention

It is an object of the present invention to provide an apparatus with which a stamp can be moved down while displacement in the x,y-plane and rotations about the x-, y- and z-axes can be measured very accurate. To this end the apparatus according to the invention comprises:
- three plane mirrors, which are present at least substantially perpendicular to the z-direction on the top side of the stamp,
- three pairs of further plane mirrors at right angles to each other, which are attached to the stamp at, at least three different locations in an orientation whereby the intersection line of the further plane mirrors extends in a direction at least substantially parallel to the z-direction,
- at least three interferometers which are present at a distance above or below the stamp in the z-direction, the light beams of which are at least substantially perpendicular to the plane mirrors,
- at least three further interferometers which are present at a distance next to the stamp in the x- and y-directions, the light beams of the further interferometers are at an angle not equal to 90 degrees to one of the further plane mirrors of a pair, and
- at least three zero-shear mirrors which are at least substantially perpendicular to the light beams returning from the further plane mirrors and which are present adjacent to the further interferometers,
whereby the further plane mirrors of the pairs are elongated and extend in the z-direction.

Making use of long flat mirrors at 90 degrees and a zero-shear mirror at the side of the interferometer allow great vertical movement and still small rotation about z-axis and small x,y-displacements. Tip/tilt motions are not allowed by this configuration, but also not wanted/needed for this application.

Preferably, the length in z-direction of the further plane mirror of the pairs is greater than or equal to the distance in the z-direction over which the stamp is moved.

The terms stamp and substrate used in the description and claims can be any object other than a stamp or a substrate.

### Brief description of the drawings

The invention will be further elucidated below on the basis of drawings. These drawings show an embodiment of the apparatus according to the present invention. In the drawings:
Figure 1 is a schematic representation of the apparatus according to the invention in side view; and
Figure 2 is the apparatus shown in figure 1 in top view.

### Detailed description of the drawings

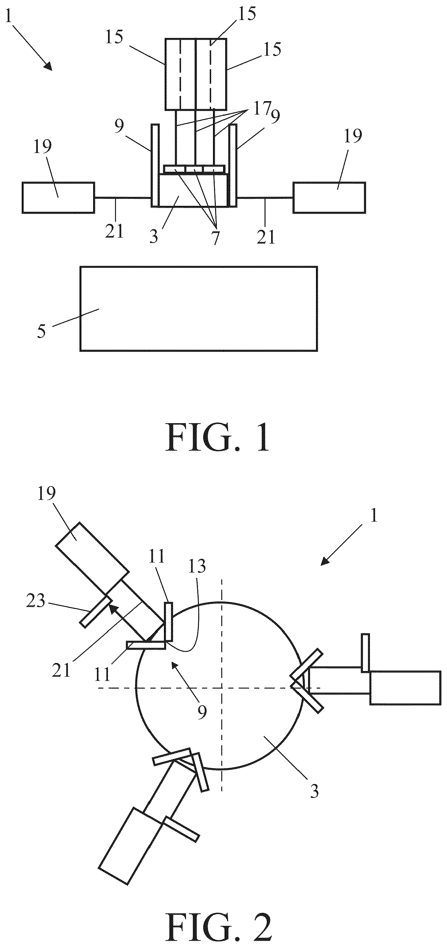

In Figures 1 and 2, an embodiment of the apparatus for accurately moving a stamp to a substrate according to the invention is shown in a side view and in a top view respectively. The stamp 3 is moved in the z-direction over a greater distance than in the x- and y-directions. The apparatus 1 comprises three plane mirrors 7, which are present at least substantially perpendicular to the z-direction on the top side of the stamp 3, and three pairs 9 of further plane mirrors 11 at right angles to each other. The pairs 9 of further plane mirrors 11 are attached to the stamp 3 at three different locations in an orientation whereby the intersection line 13 of the further plane mirrors 11 extends in a direction at least substantially parallel to the z-direction.

The apparatus 1 further comprises three interferometers 15 which are present at a distance above the stamp 3 in the z-direction, the light beams 17 of which are at least substantially perpendicular to the plane mirrors 7, and three further interferometers 19 which are present at a distance next to the stamp 3 in the x- and y-directions, the light beams 21 are at least substantially at 45 degrees to one of the further plane mirrors 11 of a pair. Adjacent each further interferometer 19 a zero-shear mirror 23 is arranged.

The further plane mirrors 11 of the pairs 9 are elongated and extend in the z-direction. The length in z-direction of the further plane mirrors 11 is greater than or equal to the distance in the z-direction over which the stamp 3 is moved.

With the aid of the mirrors and interferometers the displacement in the x-, y- and z-directions and the rotations about the x-, y- and z-axes of the stamp are measured. Tip/tilt motions are not allowed by this configuration, but also not wanted/needed for this application.

Although the present invention is elucidated above on the basis of the given drawings, it should be noted that this invention is not limited whatsoever to the embodiments shown in the drawings. The invention also extends to all embodiments deviating from the embodiments shown in the drawings within the scope of the invention defined by the appended claims.

## Claims

1. Apparatus (1) for accurately moving a stamp (3) to a substrate (5), whereby the displacement in the x-, y- and z-directions and the rotation about the x-, y- and z-axes of the stamp are measured and whereby the stamp (3) is moved in the z-direction to the substrate (5), the stamp (3) is moved in the z-direction over a greater distance than in the x- and y-directions, the apparatus (1) comprising:
- three plane mirrors (7), which are present at least substantially perpendicular to the z-direction on the top side of the stamp (3),
- three pairs (9) of further plane mirrors (11) at right angles to each other, which are attached to the stamp (3) at, at least three different locations in an orientation whereby the intersection line (13) of the further plane mirrors (11) extends in a direction at least substantially parallel to the z-direction,
- at least three interferometers (15) which are present at a distance above or below the stamp (3) in the z-direction, the light beams (17) of which are at least substantially perpendicular to the plane mirrors (7),
- at least three further interferometers (19) which are present at a distance next to the stamp (3) in the x- and y-directions, the light beams (21) of the further interferometers are at an angle not equal to 90 degrees to one of the further plane mirrors (11) of a pair, and
- at least three zero-shear mirrors (23) which are at least substantially perpendicular to the light beams returning from the further plane mirrors (11) and which are present adjacent to the further interferometers (19),
whereby the further plane mirrors (11) of the pairs (9) are elongated and extend in the z-direction.

2. Device (1) according to claim 1, **characterized in that** the length in z-direction of the further plane mirrors (11) of the pairs (9) is greater than or equal to the distance in the z-direction over which the stamp (3) is moved.
